# EUROPEAN PATENT APPLICATION

(11) **EP 4 707 661 A1**
(43) Date of publication of application: **11.03.2026**
(21) Application number: 24814350.5
(22) Date of filing: 24.05.2024
(51) Int. Cl.: F17D 1/04

(54) **GAS PROTECTION SYSTEM, GAS PROTECTION METHOD, AND ENERGY STORAGE SYSTEM**

(30) Priority: 31.05.2023 CN 202310640755
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: SUN, Lijun, Shanghai 201100 (CN); TU, Minjie, Shanghai 201100 (CN); LU, Yanhua, Shanghai 201100 (CN); GUO, Zide, Shanghai 201100 (CN)
(74) Representative: Gong, Jinping
(86) International application number: PCT/CN2024/095291
(87) International publication number: WO 2024/245153

(57) **Abstract**

A gas protection system, a gas protection method, and an energy storage system are provided. The gas protection system (10) includes: a gas transmission pipe (11) in communication with a sealed cabinet (1), where the gas transmission pipe is configured to input and output a protective gas to and from the sealed cabinet; a first detection module (12) disposed in the gas transmission pipe; and a gas supply module (13) configured to acquire gas parameters of the protective gas in the gas transmission pipe from the first detection module and supply a gas to the sealed cabinet based on the gas parameters. The gas protection system can mitigate the issue of thermal runaway in the sealed cabinet.

## Description

### CROSS-REFERENCE TO RELATED APPLICATIONS

This application claims priority to Chinese Patent Application No. 2023106407557, filed on May 31, 2023 and entitled "GAS PROTECTION SYSTEM, GAS PROTECTION METHOD, AND ENERGY STORAGE SYSTEM", which is incorporated herein by reference in its entirety.

### TECHNICAL FIELD

This application relates to the technical field of energy storage systems, and in particular, to a gas protection system, a gas protection method, and an energy storage system.

### BACKGROUND

Electronic components in a sealed cabinet generate a large amount of heat during operation, making the electronic components prone to thermal runaway issues. For example, in an energy storage system, batteries in a sealed cabinet are highly susceptible to thermal runaway under conditions such as short circuits, overcharging, over-discharging, and thermal abuse. If thermal runaway gases from the battery reach a certain concentration in a confined space, large-scale fires or even explosions may occur when the gases encounter an ignition source.

In related art, to address thermal runaway issues at the source, nitrogen is filled into the sealed cabinet or the electronic components in the sealed cabinet to protect the sealed cabinet and the electronic components. However, effective monitoring of nitrogen supply to the sealed cabinet has not been achieved, resulting in suboptimal improvements to thermal failure.

### SUMMARY

In view of the above issues, this application provides a gas protection system, a gas protection method, and an energy storage system to address issues such as thermal runaway in a sealed cabinet.

To address the above technical issues, this application proposes a gas protection system. The gas protection system is configured to provide gas protection for a sealed cabinet. The gas protection system includes: a gas transmission pipe in communication with the sealed cabinet, where the gas transmission pipe is configured to input and output a protective gas to and from the sealed cabinet; a first detection module disposed in the gas transmission pipe; and a gas supply module configured to acquire gas parameters of the protective gas in the gas transmission pipe from the first detection module and supply a gas to the sealed cabinet based on the gas parameters.

The gas protection system provided by this application enables input and output of the protective gas in the sealed cabinet through the gas transmission pipe. The first detection module disposed in the gas transmission pipe in communication with the sealed cabinet is configured to acquire the gas parameters of the protective gas in the gas transmission pipe. This configuration allows the first detection module to be positioned away from the sealed cabinet, thereby reducing interference of the sealed cabinet on the first detection module and improving the accuracy of gas parameter detection. Furthermore, in this application, the gas supply module is further configured to acquire the gas parameters of the protective gas in the gas transmission pipe from the first detection module and supply the gas to the sealed cabinet based on the gas parameters, enabling monitoring of the protective gas in the sealed cabinet and improving the accuracy of gas supply to the sealed cabinet. Thus, accurate monitoring of gas supply to the sealed cabinet can be achieved in this application, ensuring controllable protective gas parameters during normal operation of the sealed cabinet, significantly mitigating the issues such as thermal runaway in the sealed cabinet, and enabling effective discharge of thermal failure gases in a thermal failure state of the sealed cabinet.

In some embodiments, the first detection module includes at least one of a temperature and humidity detection mechanism, a pressure detection mechanism, and a flow rate detection mechanism.

In these embodiments, at least one of a gas temperature, a gas humidity, a gas pressure, and a gas flow rate of the protective gas can be acquired through at least one of the temperature and humidity detection mechanism, the pressure detection mechanism, and the flow rate detection mechanism.

In some embodiments, the gas transmission pipe includes an intake pipe and an exhaust pipe, and the gas protection system includes two first detection modules respectively disposed in the exhaust pipe and the intake pipe.

In these embodiments, the first detection modules are disposed in both the exhaust pipe and the intake pipe of the sealed cabinet, enabling respective acquisitions of gas parameters of a protective gas in the exhaust pipe and gas parameters of a protective gas in the intake pipe, and enabling monitoring of the intake and exhaust of the protective gas in the sealed cabinet, thereby further improving the monitoring accuracy of the protective gas in the sealed cabinet, improving the accuracy of gas supply to the sealed cabinet, and further mitigating the issues such as thermal runaway in the sealed cabinet.

In some embodiments, the gas supply module includes: a control mechanism connected to the first detection module, where the control mechanism is configured to acquire the gas parameters from the first detection module and generate a first control signal and a second control signal based on the gas parameters; and a gas supply mechanism in communication with the gas transmission pipe and configured to acquire the first control signal from the control mechanism and supply the protective gas to the gas transmission pipe based on the first control signal.

In these embodiments, the gas supply mechanism can be controlled by the control mechanism to supply the protective gas.

In some embodiments, the gas supply module further includes: a mode switching mechanism disposed on the gas transmission pipe; where the gas transmission pipe includes: a first pipe segment in communication with both an exhaust port of the sealed cabinet and the mode switching mechanism; a second pipe segment in communication with both the mode switching mechanism and the gas supply mechanism; and a third pipe segment in communication with both an intake port of the sealed cabinet and the gas supply mechanism; where the control mechanism is configured to generate a second control signal based on the gas parameters, and the mode switching mechanism is configured to acquire the second control signal from the control mechanism and, based on the second control signal, enable communication between the first pipe segment and the second pipe segment while disabling communication between the first pipe segment and an external environment, or disable communication between the first pipe segment and the second pipe segment while enabling communication between the first pipe segment and the external environment.

In these embodiments, switching of gas circulation modes of the protective gas can be achieved through the mode switching mechanism, allowing the gas circulation modes to be switched based on the gas parameters of the protective gas in the sealed cabinet, thereby allowing the supply of the protective gas to better meet a current condition of the sealed cabinet, improving the accuracy of gas supply to the sealed cabinet, and further mitigating the issues such as thermal runaway in the sealed cabinet.

In some embodiments, the gas supply mechanism includes: a gas replenishment mechanism connected to the control mechanism and configured to supply the protective gas or stop supplying the protective gas under control of the control mechanism.

In these embodiments, the gas replenishment mechanism can supply the gas to the sealed cabinet.

In some embodiments, the gas supply mechanism further includes: a pressure stabilization mechanism connected to the control mechanism and in communication with the gas replenishment mechanism through a gas supply pipe, where the pressure stabilization mechanism is also in communication with the gas transmission pipe, and the pressure stabilization mechanism is configured to stabilize pressure of the protective gas output from the gas replenishment mechanism under control of the control mechanism and then deliver the protective gas to the gas transmission pipe.

In these embodiments, the gas replenishment mechanism and the pressure stabilization mechanism allow the gas supply mechanism to not only supply the gas to the sealed cabinet but also regulate the pressure or flow rate of the protective gas. This can further mitigate the issues such as thermal runaway in the sealed cabinet and reduce dissipation of the protective gas.

In some embodiments, the gas supply mechanism further includes: a second detection module disposed in the gas supply pipe and connected to the control mechanism, where the second detection module is configured to transmit gas replenishment parameters acquired to the control mechanism.

In these embodiments, gas parameters of the gas replenishment mechanism are acquired through the second detection module, facilitating gas supply control by the control mechanism and improving the accuracy of gas supply to the sealed cabinet.

To address the above technical issues, this application proposes a gas protection method. The gas protection method includes: acquiring gas parameters of a protective gas in a gas transmission pipe of a sealed cabinet; and supplying a gas to the sealed cabinet based on the gas parameters.

In this embodiment, input and output of the protective gas in the sealed cabinet can be achieved through the gas transmission pipe. A first detection module disposed in the gas transmission pipe in communication with the sealed cabinet is configured to acquire gas parameters of the protective gas in the gas transmission pipe. This configuration allows the first detection module to be positioned away from the sealed cabinet, thereby reducing interference of the sealed cabinet on the first detection module and improving the accuracy of gas parameter detection. Furthermore, in this embodiment, the gas parameters of the protective gas in the gas transmission pipe are further acquired from the first detection module, and the gas is supplied to the sealed cabinet based on the gas parameters, enabling monitoring of the protective gas in the sealed cabinet and improving the accuracy of gas supply to the sealed cabinet. Thus, accurate monitoring of gas supply to the sealed cabinet can be achieved in this embodiment, ensuring controllable protective gas parameters during normal operation of the sealed cabinet, significantly mitigating the issues such as thermal runaway in the sealed cabinet, and enabling effective discharge of thermal failure gases in a thermal failure state of the sealed cabinet.

In some embodiments, the gas transmission pipe includes an intake pipe and an exhaust pipe, and the gas parameters include intake gas parameters and exhaust gas parameters; and the acquiring gas parameters of a protective gas in a gas transmission pipe of a sealed cabinet includes: acquiring the intake gas parameters of the protective gas in the intake pipe and the exhaust gas parameters of the protective gas in the exhaust pipe, respectively.

In these embodiments, monitoring of the intake and exhaust of the protective gas in the sealed cabinet can be achieved, thereby further improving the monitoring accuracy of the protective gas in the sealed cabinet, improving the accuracy of gas supply to the sealed cabinet, and further mitigating the issues such as thermal runaway in the sealed cabinet.

In some embodiments, the intake gas parameters include an intake temperature, and the exhaust gas parameters include an exhaust temperature; and the supplying a gas to the sealed cabinet based on the gas parameters includes: in response to the exhaust temperature or the intake temperature being greater than or equal to a temperature threshold, or a temperature difference between the exhaust temperature and the intake temperature being greater than or equal to a difference threshold, supplying the gas to the sealed cabinet through the intake pipe at a first preset flow rate and discharging the protective gas in the sealed cabinet to an external environment through the exhaust pipe.

In these embodiments, the thermal failure issue can be monitored and mitigated through the intake temperature or the exhaust temperature. Alternatively, the thermal failure issue can be monitored and mitigated through the difference between the intake temperature and the exhaust temperature.

In some embodiments, the intake gas parameters include an intake humidity, and the exhaust gas parameters include an exhaust humidity; and the supplying a gas to the sealed cabinet based on the gas parameters includes: in response to the exhaust humidity or the intake humidity being greater than or equal to a humidity threshold, supplying the gas to the sealed cabinet through the intake pipe at a first preset flow rate and discharging the protective gas in the sealed cabinet to an external environment through the exhaust pipe.

In these embodiments, the thermal failure issue can be monitored and mitigated through the exhaust humidity or the intake humidity.

In some embodiments, the intake gas parameters include an intake pressure and/or an intake flow rate, and the exhaust gas parameters include an exhaust pressure and/or an exhaust flow rate; and the supplying a gas to the sealed cabinet based on the gas parameters includes: in response to the intake pressure being less than or equal to a first intake pressure threshold and greater than a second intake pressure threshold, and/or the intake flow rate being less than or equal to a first intake flow rate threshold and greater than a second intake flow rate threshold, supplying the gas to the sealed cabinet through the intake pipe at a first preset flow rate and discharging the protective gas in the sealed cabinet to an external environment through the exhaust pipe; or in response to the exhaust pressure being less than or equal to a first exhaust pressure threshold and greater than a second exhaust pressure threshold, and/or the exhaust flow rate being less than or equal to a first exhaust flow rate threshold and greater than a second exhaust flow rate threshold, supplying the gas to the sealed cabinet through the intake pipe at a first preset flow rate and discharging the protective gas in the sealed cabinet to an external environment through the exhaust pipe.

In these embodiments, the slight gas leakage can be monitored and the gas leakage issue can be mitigated through the gas pressure and/or the gas flow rate.

In some embodiments, the supplying a gas to the sealed cabinet based on the gas parameters further includes: in response to the intake pressure being less than or equal to the second intake pressure threshold and greater than a third intake pressure threshold, and/or the intake flow rate being less than or equal to the second intake flow rate threshold and greater than a third intake flow rate threshold, supplying the gas to the sealed cabinet through the intake pipe at a second preset flow rate and discharging the protective gas in the sealed cabinet to an external environment through the exhaust pipe; or in response to the exhaust pressure being less than or equal to the second exhaust pressure threshold and greater than a third exhaust pressure threshold, and/or the exhaust flow rate being less than or equal to the second exhaust flow rate threshold and greater than a third exhaust flow rate threshold, supplying the gas to the sealed cabinet through the intake pipe at a second preset flow rate and discharging the protective gas in the sealed cabinet to an external environment through the exhaust pipe; where the second preset flow rate is less than the first preset flow rate.

In these embodiments, relatively severe gas leakage can be monitored and the gas leakage issue can be mitigated through the gas pressure and/or the gas flow rate.

In some embodiments, the supplying a gas to the sealed cabinet based on the gas parameters further includes: in response to the intake pressure being less than or equal to the third intake pressure threshold, and/or the intake flow rate being less than or equal to the third intake flow rate threshold, controlling the intake pipe to stop supplying the gas to the sealed cabinet and discharging the protective gas in the sealed cabinet to an external environment through the exhaust pipe; or in response to the exhaust pressure being less than or equal to the third exhaust pressure threshold, and/or the exhaust flow rate being less than or equal to the third exhaust flow rate threshold, controlling the intake pipe to stop supplying the gas to the sealed cabinet and discharging the protective gas in the sealed cabinet to an external environment through the exhaust pipe.

In these embodiments, very severe gas leakage can be monitored and the gas leakage issue can be mitigated through the gas pressure and/or the gas flow rate.

In some embodiments, the gas protection method further includes: acquiring gas replenishment parameters of the sealed cabinet, a gas circulation mode of the protective gas, and an operating mode of the sealed cabinet; and determining whether leakage occurs in the sealed cabinet based on the gas replenishment parameters, the operating mode, and the gas circulation mode.

In these embodiments, further acquiring the gas replenishment parameters, the gas circulation mode, and the operating mode of the sealed cabinet, and determining whether leakage occurs in the sealed cabinet based on the gas replenishment parameters, the operating mode, and the gas circulation mode can further improve the accuracy of monitoring of gas supply to the sealed cabinet and mitigate the risk of safety incidents. Monitoring of the gas pressure and monitoring of the flow rate cannot obtain the specific leakage rate of the protective gas in the gas protection system. In these embodiments, the leakage rate of the protective gas can also be calculated based on a gas replenishment amount and an exhaust flow rate.

In some embodiments, the gas replenishment parameters include a gas replenishment amount; and the determining whether leakage occurs in the gas protection system based on the gas replenishment parameters, the operating mode, and the gas circulation mode includes: in response to the operating mode being a normal mode, the gas circulation mode being an internal circulation mode, and the gas replenishment amount being greater than zero, determining that leakage of the protective gas occurs.

When the sealed cabinet is in the normal mode and the protective gas is in the internal circulation mode, the gas replenishment amount can be monitored to determine whether leakage of the protective gas occurs.

In some embodiments, the gas replenishment parameters include a gas replenishment amount; and the determining whether leakage occurs in the gas protection system based on the gas replenishment parameters, the operating mode, and the gas circulation mode includes: in response to the operating mode being a normal mode, the gas circulation mode being an external circulation mode, and a difference between the gas replenishment amount and an exhaust flow rate of the gas transmission pipe being greater than zero, determining that leakage of the protective gas occurs.

When the sealed cabinet is in the normal mode and the protective gas is in the external circulation mode, whether leakage of the protective gas occurs can be determined based on the gas replenishment amount and the exhaust flow rate.

In some embodiments, the gas replenishment parameters include a gas replenishment amount; and the determining whether leakage occurs in the gas protection system based on the gas replenishment parameters, the operating mode, and the gas circulation mode includes: in response to the operating mode being a thermal failure mode, the gas circulation mode being an external circulation mode, and a difference between the gas replenishment amount and an exhaust flow rate of the gas transmission pipe being greater than zero, determining that the gas protection system has leakage outward; or in response to the operating mode being a thermal failure mode and the difference between the gas replenishment amount and the exhaust flow rate of the gas transmission pipe being less than zero, determining that there is leakage from the environment to the gas protection system.

When the sealed cabinet is in the thermal failure mode and the protective gas is in the external circulation mode, the gas replenishment amount and the exhaust flow rate can be used for determining whether leakage of the protective gas occurs and identifying the leakage cause.

To address the above technical issues, this application proposes an energy storage system. The energy storage system includes: a sealed cabinet provided with an energy storage component inside; and the gas protection system described above, where the gas transmission pipe is in communication with the sealed cabinet.

Distinguished from the prior art, the gas protection system provided by this application enables input and output of the protective gas in the sealed cabinet through the gas transmission pipe. The first detection module disposed in the gas transmission pipe in communication with the sealed cabinet is configured to acquire the gas parameters of the protective gas in the gas transmission pipe. This configuration allows the first detection module to be positioned away from the sealed cabinet, thereby reducing interference of the sealed cabinet on the first detection module and improving the accuracy of gas parameter detection. Furthermore, in this application, the gas supply module is further configured to acquire the gas parameters of the protective gas in the gas transmission pipe from the first detection module and supply the gas to the sealed cabinet based on the gas parameters, enabling monitoring of the protective gas in the sealed cabinet and improving the accuracy of gas supply to the sealed cabinet. Thus, accurate monitoring of gas supply to the sealed cabinet can be achieved in this application, ensuring controllable protective gas parameters during normal operation of the sealed cabinet, significantly mitigating the issues such as thermal runaway in the sealed cabinet, and enabling effective discharge of thermal failure gases in a thermal failure state of the sealed cabinet.

### BRIEF DESCRIPTION OF DRAWINGS

To describe the technical solutions in the embodiments of this application or the prior art more clearly, the following briefly describes the accompanying drawings required for describing the embodiments or the prior art. Apparently, the accompanying drawings in the following description show merely some embodiments of this application, and persons of ordinary skill in the art may still derive other drawings from these accompanying drawings. In the accompanying drawings:
FIG. 1 is a schematic structural diagram of an embodiment of a gas protection system and a sealed cabinet according to this application;
FIG. 2 is a schematic structural diagram of an embodiment of a gas transmission pipe and a first detection module according to this application;
FIG. 3 is a schematic structural diagram of an embodiment of an energy storage system and a gas transmission pipe according to this application;
FIG. 4 is a schematic flowchart of an embodiment of a gas protection method according to this application; and
FIG. 5 is a schematic flowchart of another embodiment of a gas protection method according to this application.

Reference signs: sealed cabinet 1; energy storage component 2; energy storage valve 3; gas protection system 10; gas transmission pipe 11; first detection module 12; gas supply module 13; intake pipe 111; exhaust pipe 112; branch pipe 113; temperature and humidity detection mechanism 121; pressure detection mechanism 122; flow rate detection mechanism 123; gas supply pipe 131; gas supply mechanism 132; mode switching mechanism 133; gas replenishment mechanism 134; pressure stabilization mechanism 135; power mechanism 136; and second detection module 137.

### DESCRIPTION OF EMBODIMENTS

The following describes in detail embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by persons skilled in the art to which this application relates. The terms used herein are intended to merely describe the specific embodiments rather than to limit this application. The terms "comprise", "include", "have", and any other variations thereof in the specification, claims and brief description of accompanying drawings of this application are intended to cover non-exclusive inclusions.

In the description of the embodiments of this application, the technical terms "first", "second", and the like are merely intended to distinguish between different objects, and shall not be understood as any indication or implication of relative importance or any implicit indication of the number, specific sequence, or primary-secondary relationship of the technical features indicated. In the description of the embodiments of this application, "a plurality of" means two or more, unless otherwise explicitly and specifically defined.

Reference to "embodiment" in the specification means that specific features, structures, or characteristics described with reference to an embodiment may be included in at least one embodiment of this application. The word "embodiment" appearing in various places in this specification does not necessarily refer to the same embodiment or an independent or alternative embodiment that is exclusive of other embodiments. Persons skilled in the art explicitly and implicitly understand that the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between the contextually associated objects.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of description of these embodiments of this application rather than indicating or implying that the means or components mentioned must have specific orientations or must be constructed or manipulated according to specific orientations, and therefore shall not be construed as any limitations on these embodiments of this application.

In the description of the embodiments of this application, unless otherwise specified and defined explicitly, the technical terms "mounting", "connection", "join", and "fastening" should be understood in their general senses. For example, they may refer to a fixed connection, a detachable connection, or an integral connection, may refer to a mechanical connection or electrical connection, and may refer to a direct connection, an indirect connection via an intermediate medium, an internal communication between two elements, or an interaction between two elements.

With the continuous development of electronic technology, higher requirements have been placed on the integration of electronic systems or electronic components. The electronic components are typically integrated in a sealed cabinet. However, the electronic components in the sealed cabinet generate a large amount of heat during operation, making the electronic components prone to thermal runaway issues. For example, in an energy storage system, batteries in a sealed cabinet are highly susceptible to thermal runaway under conditions such as short circuits, overcharging, over-discharging, and thermal abuse, producing flammable or toxic gases such as H₂, hydrocarbons, and CO. If thermal runaway gases from the battery reach a certain concentration in a confined space, large-scale fires or even explosions may occur when the gases encounter an ignition source.

In related art, to address thermal runaway issues at the source, nitrogen is filled into the sealed cabinet or the electronic components in the sealed cabinet to protect the sealed cabinet and the electronic components. However, effective monitoring of nitrogen supply to the sealed cabinet has not been achieved, resulting in suboptimal improvements to thermal failure.

To address the above issues, this application proposes a gas protection system, a gas protection method, and an energy storage system, capable of accurately acquiring gas parameters of a protective gas and supplying a gas to a sealed cabinet based on the gas parameters, thereby improving the accuracy of gas supply to the sealed cabinet. Thus, accurate monitoring of gas supply to the sealed cabinet can be achieved, significantly mitigating the issues such as thermal runaway in the sealed cabinet.

The gas protection system and the gas protection method disclosed in the embodiments of this application may be applied to an energy storage system to mitigate the issues such as thermal runaway in the sealed cabinet. The gas protection system and the gas protection method disclosed in the embodiments of this application may also be applied to other electronic devices with sealed structures.

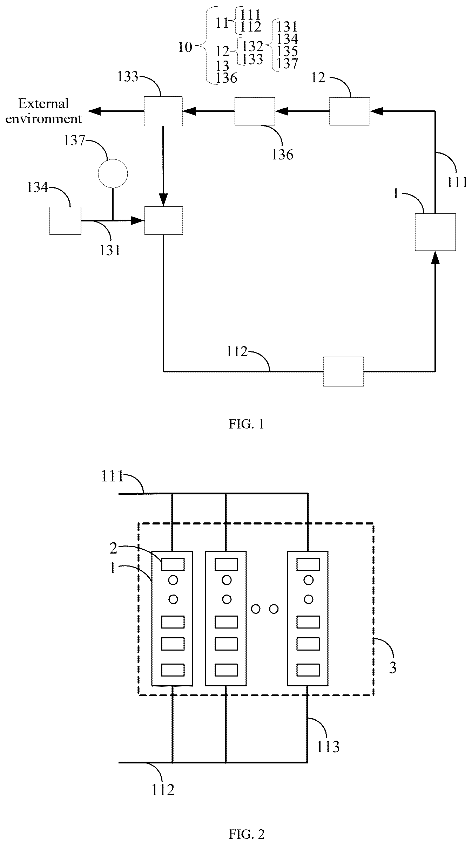

This application first proposes a gas protection system. As shown in FIG. 1, FIG. 1 is a schematic structural diagram of an embodiment of a gas protection system and a sealed cabinet according to this application. The gas protection system 10 of this embodiment is configured to provide gas protection for the sealed cabinet 1. The gas protection system 10 includes: a gas transmission pipe 11, a first detection module 12, and a gas supply module 13, where the gas transmission pipe 11 is in communication with the sealed cabinet 1, and the gas transmission pipe 11 is configured to input and output a protective gas to and from the sealed cabinet 1; the first detection module 12 is disposed in the gas transmission pipe 11; and the gas supply module 13 is configured to acquire gas parameters of the protective gas in the gas transmission pipe 11 from the first detection module 12 and supply a gas to the sealed cabinet 1 based on the gas parameters.

Specifically, the sealed cabinet 1 refers to a container having sealing performance and capable of achieving sealed placement of components or assemblies in its accommodation cavity; the gas supply module 13 refers to a component or assembly that generates the protective gas and controls the output of the protective gas; and the first detection module 12 being disposed in the gas transmission pipe 11 means that a gas detection portion of the first detection module 12 is disposed in the gas transmission pipe 11 to acquire the gas parameters of the protective gas in the gas transmission pipe 11.

Optionally, the protective gas of this embodiment may include, but is not limited to, inert gases such as nitrogen and xenon.

The gas protection system provided by this embodiment enables input and output of the protective gas in the sealed cabinet 1 through the gas transmission pipe 11. The first detection module 12 disposed in the gas transmission pipe 11 in communication with the sealed cabinet 1 is configured to acquire the gas parameters of the protective gas in the gas transmission pipe 11. This configuration allows the first detection module 12 to be positioned away from the sealed cabinet 1, thereby reducing interference of the sealed cabinet 1 on the first detection module 12 and improving the accuracy of gas parameter detection. Furthermore, in this embodiment, the gas supply module 13 is further configured to acquire the gas parameters of the protective gas in the gas transmission pipe 11 from the first detection module 12 and supply the gas to the sealed cabinet 1 based on the gas parameters, enabling monitoring of the protective gas in the sealed cabinet 1 and improving the accuracy of gas supply to the sealed cabinet 1. Thus, accurate monitoring of gas supply to the sealed cabinet 1 can be achieved in this embodiment, ensuring controllable protective gas parameters during normal operation of the sealed cabinet 1, significantly mitigating the issues such as thermal runaway in the sealed cabinet 1, and enabling effective discharge of thermal failure gases in a thermal failure state of the sealed cabinet 1.

In some embodiments, the first detection module 12 includes at least one of a temperature and humidity detection mechanism, a pressure detection mechanism, and a flow rate detection mechanism.

The temperature and humidity detection mechanism refers to a component or assembly with functions for acquiring temperature information and humidity information. The temperature and humidity detection mechanism of this embodiment may include a temperature sensor and a humidity sensor that are integrated, or may include a temperature sensor and a humidity sensor that are separately disposed.

The pressure detection mechanism refers to a component or assembly with a function for acquiring gas pressure. The pressure detection mechanism of this embodiment may include, but is not limited to, a pressure sensor. The pressure sensor may be a capacitive pressure sensor, a piezoelectric pressure sensor, or the like.

The flow rate detection mechanism refers to a component or assembly with a function for acquiring a gas flow rate. The flow rate detection mechanism of this embodiment may include, but is not limited to, a flow rate meter.

The gas parameters of this embodiment may include at least one of a gas temperature, a gas humidity, a gas pressure, and a gas flow rate, which may be acquired through corresponding detection mechanisms.

In this embodiment, at least one of the gas temperature, the gas humidity, the gas pressure, and the gas flow rate of the protective gas can be acquired through at least one of the temperature and humidity detection mechanism, the pressure detection mechanism, and the flow rate detection mechanism.

In some embodiments, the gas transmission pipe 11 includes an intake pipe 111 and an exhaust pipe 112, and the gas protection system includes two first detection modules 12 respectively disposed in the exhaust pipe 112 and the intake pipe 111.

In these embodiments, the first detection modules 12 are disposed in both the exhaust pipe 112 and the intake pipe 111 of the sealed cabinet 1, enabling respective acquisitions of gas parameters of a protective gas in the exhaust pipe 112 and gas parameters of a protective gas in the intake pipe 111, and enabling monitoring of the intake and exhaust of the protective gas in the sealed cabinet 1, thereby further improving the monitoring accuracy of the protective gas in the sealed cabinet 1, improving the accuracy of gas supply to the sealed cabinet 1, and further mitigating the issues such as thermal runaway in the sealed cabinet.

In some embodiments, the gas supply module 13 includes: a control mechanism and a gas supply mechanism 132, where the control mechanism is connected to the first detection module 12, and the control mechanism is configured to acquire the gas parameters from the first detection module 12 and generate a first control signal and a second control signal based on the gas parameters; and the gas supply mechanism 132 is in communication with the gas transmission pipe 11 and is configured to acquire the first control signal from the control mechanism and supply the protective gas to the gas transmission pipe 11 based on the first control signal.

Specifically, the control mechanism being connected to the first detection module 12 means that the control mechanism is electrically connected to the first detection module 12, enabling the control mechanism to control the operation of the first detection module 12 and acquire the gas parameters from the first detection module 12; and the first control signal may include a gas replenishment command to control the gas supply mechanism to replenish a gas to the sealed cabinet 1 through the gas transmission pipe 11.

In these embodiments, the protective gas can be supplied through the gas supply mechanism 132.

In some embodiments, the gas supply module 13 further includes: a mode switching mechanism 133, the mode switching mechanism 133 being disposed on the gas transmission pipe, where the gas transmission pipe 11 includes: a first pipe segment in communication with both an exhaust port of the sealed cabinet 1 and the mode switching mechanism 133; a second pipe segment in communication with both the mode switching mechanism 133 and the gas supply mechanism 132; and a third pipe segment in communication with both an intake port of the sealed cabinet 1 and the gas supply mechanism 132; where the control mechanism is configured to generate a second control signal based on the gas parameters, and the mode switching mechanism 133 is configured to acquire the second control signal from the control mechanism and, based on the second control signal, enable communication between the first pipe segment to the second pipe segment while disabling communication between the first pipe segment and an external environment, or disable communication between the first pipe segment and the second pipe segment while enabling communication between the first pipe segment and the external environment.

Specifically, the second control signal may include a switching command to control the mode switching mechanism 133 to switch gas circulation modes of the protective gas in the gas transmission pipe 11. The mode switching mechanism 133 controls the gas transmission pipe 11 to be in communication with the gas supply mechanism 132 or the external environment based on the second control signal, thereby switching the gas circulation modes of the protective gas.

The gas circulation modes refer to circulation flow modes of the protective gas in the gas transmission pipe 11, including an internal circulation mode and an external circulation mode. The internal circulation mode indicates that the protective gas discharged from the sealed cabinet 1 circulates directly in the gas protection system 10 through the gas transmission pipe 11 without being discharged to the external environment. The external circulation mode indicates that the gas discharged from the sealed cabinet 1 is discharged to the external environment through the gas transmission pipe 11, and the gas is replenished to the sealed cabinet 1 through the gas transmission pipe 11.

The mode switching mechanism 133 being disposed on the gas transmission pipe 11 means that the mode switching mechanism 133 is disposed in a flow path of the gas transmission pipe 11 and is capable of switching flow directions of the protective gas in the gas transmission pipe 11 to switch the gas circulation modes.

Specifically, the gas transmission pipe 11 may include a first pipe segment for enabling communication between the sealed cabinet 1 and the mode switching mechanism 133, a second pipe segment for enabling communication between the mode switching mechanism 133 and the gas supply mechanism 132, and a third pipe segment for enabling communication between the gas supply mechanism 132 and the sealed cabinet 1. The first pipe segment and the second pipe segment may serve as the exhaust pipe 112 of the gas transmission pipe 11, and the third pipe segment may serve as the intake pipe 111 of the gas transmission pipe 11.

Optionally, the mode switching mechanism 133 may include a three-way valve with three ports in communication with the first pipe segment, the second pipe segment, and the external environment, respectively. The control mechanism controls the three-way valve through the second control signal to enable communication between the first pipe segment and the second pipe segment, enabling the protective gas to form an internal circulation in the first pipe segment, the second pipe segment, and the third pipe segment of the gas transmission pipe 11, thereby controlling the protective gas to enter the internal circulation mode. Alternatively, the control mechanism controls the three-way valve through the second control signal to disable communication between the first pipe segment and the second pipe segment and enable communication between the first pipe segment and the external environment, thereby controlling the protective gas to enter the external circulation mode.

The control mechanism is also electrically connected to the gas supply mechanism 132 to control the operation of the gas supply mechanism 132.

In these embodiments, switching of gas circulation modes of the protective gas can be achieved through the mode switching mechanism 133, allowing the gas circulation modes to be switched based on the gas parameters of the protective gas in the sealed cabinet, thereby allowing the supply of the protective gas to better meet a current condition of the sealed cabinet, improving the accuracy of gas supply to the sealed cabinet 1, and further mitigating the issues such as thermal runaway in the sealed cabinet.

In other embodiments, to simplify the structure, the control mechanism may be omitted.

In some embodiments, the gas supply mechanism 132 includes: a gas replenishment mechanism 134, where the gas replenishment mechanism 134 is connected to the control mechanism and configured to supply the protective gas or stop supplying the protective gas under control of the control mechanism.

In these embodiments, the gas replenishment mechanism 134 can supply the gas to the sealed cabinet 1.

In some embodiments, the gas supply mechanism 132 further includes: a pressure stabilization mechanism 135, where the pressure stabilization mechanism 135 is connected to the control mechanism and is in communication with the gas replenishment mechanism 134 through a gas supply pipe 131, the pressure stabilization mechanism 135 is also in communication with the gas transmission pipe 11, and the pressure stabilization mechanism 135 is configured to stabilize pressure of the protective gas output from the gas replenishment mechanism 134 under control of the control mechanism and then deliver the protective gas to the gas transmission pipe 11.

Specifically, the gas replenishment mechanism 134 may also be referred to as a gas storage mechanism or a gas generation mechanism configured to supply the protective gas; and the pressure stabilization mechanism 135 refers to a component or assembly configured to regulate the pressure or flow rate of the protective gas.

In these embodiments, the gas replenishment mechanism 134 and the pressure stabilization mechanism 135 allow the gas supply mechanism 132 to not only supply the gas to the sealed cabinet but also regulate the pressure or flow rate of the protective gas. This can further mitigate the issues such as thermal runaway in the sealed cabinet and reduce dissipation of the protective gas.

In some embodiments, the gas protection system 10 further includes: a power mechanism 136 disposed in the gas transmission pipe 11 and connected to the control mechanism, where the power mechanism 136 is configured to provide a circulation driving force for the protective gas in the gas transmission pipe 11 under control of the control mechanism.

Optionally, the power mechanism 136 may include, but is not limited to, a fan, capable of promoting circulation of the protective gas in the gas transmission pipe 11.

In these embodiments, the power mechanism 136 can promote circulation of the protective gas in the gas transmission pipe 11, thereby improving the efficiency of dissipating heat or other substances from the sealed cabinet by the protective gas.

In some embodiments, the gas supply mechanism 132 further includes: a second detection module 137 disposed in the gas supply pipe 131 and connected to the control mechanism, where the second detection module 137 is configured to transmit gas replenishment parameters acquired to the control mechanism.

The second detection module 137 being disposed in the gas supply pipe 131 means that a gas detection portion of the second detection module 137 is disposed in the gas supply pipe 131 to acquire the gas parameters of the protective gas in the gas supply pipe 131.

The gas parameters of the protective gas in the gas supply pipe 131 include, but are not limited to, a gas replenishment amount. The control mechanism may acquire a gas leakage amount of the gas protection system based on the gas replenishment amount. For specific details, refer to the following description.

In these embodiments, gas parameters of the gas replenishment mechanism 134 are acquired through the second detection module 137, facilitating gas supply control by the control mechanism and improving the accuracy of gas supply to the sealed cabinet.

In some embodiments, as shown in FIG. 1, the gas protection system 10 of this embodiment includes: a gas transmission pipe 11, a first detection module 12, and a gas supply module 13, where the gas transmission pipe 11 is in communication with the sealed cabinet 1, and the gas transmission pipe 11 is configured to input and output a protective gas to and from the sealed cabinet 1; the first detection module 12 is disposed in the gas transmission pipe 11; and the gas supply module 13 is configured to acquire the gas parameters of the protective gas in the gas transmission pipe 11 from the first detection module 12 and supply a gas to the sealed cabinet 1 based on the gas parameters.

The gas protection system 10 provided by this embodiment enables input and output of the protective gas in the sealed cabinet 1 through the gas transmission pipe 11. The first detection module 12 disposed in the gas transmission pipe 11 in communication with the sealed cabinet 1 is configured to acquire the gas parameters of the protective gas in the gas transmission pipe 11. This configuration allows the first detection module 12 to be positioned away from the sealed cabinet 1, thereby reducing interference of the sealed cabinet 1 on the first detection module 12 and improving the accuracy of gas parameter detection. Furthermore, in this embodiment, the gas supply module 13 is further configured to acquire the gas parameters of the protective gas in the gas transmission pipe 11 from the first detection module 12 and supply the gas to the sealed cabinet 1 based on the gas parameters, enabling monitoring of the protective gas in the sealed cabinet 1 and improving the accuracy of gas supply to the sealed cabinet 1. Thus, accurate monitoring of gas supply to the sealed cabinet 1 can be achieved in this embodiment, ensuring controllable protective gas parameters during normal operation of the sealed cabinet 1, significantly mitigating the issues such as thermal runaway in the sealed cabinet 1, and enabling effective discharge of thermal failure gases in thermal failure state of the sealed cabinet 1.

Optionally, the first detection module 12 includes at least one of a temperature and humidity detection mechanism, a pressure detection mechanism, and a flow rate detection mechanism.

In this embodiment, at least one of a gas temperature, a gas humidity, a gas pressure, and a gas flow rate of the protective gas can be acquired through at least one of the temperature and humidity detection mechanism, the pressure detection mechanism, and the flow rate detection mechanism.

The gas transmission pipe 11 includes an intake pipe 111 and an exhaust pipe 112, and the gas protection system 10 includes two first detection modules 12 respectively disposed in the exhaust pipe 112 and the intake pipe 111.

In this embodiment, the first detection modules 12 are disposed in both the exhaust pipe 112 and the intake pipe 111 of the sealed cabinet 1, enabling respective acquisitions of gas parameters of a protective gas in the exhaust pipe 112 and gas parameters of a protective gas in the intake pipe 111, and enabling monitoring of the intake and exhaust of the protective gas in the sealed cabinet 1, thereby further improving the monitoring accuracy of the protective gas in the sealed cabinet, improving the accuracy of gas supply to the sealed cabinet 1, and further mitigating the issues such as thermal runaway in the sealed cabinet.

The exhaust pipe 112 includes a first pipe segment and a second pipe segment, and the intake pipe 111 includes a third pipe segment. The gas supply module 13 includes: a gas supply mechanism 132, a mode switching mechanism 133, and a power mechanism 136. The gas supply mechanism 132 includes: a gas replenishment mechanism 134, a pressure stabilization mechanism 135, a gas supply pipe 131, and a second detection module 137. The first pipe segment is configured to enable communication between the sealed cabinet 1 and the mode switching mechanism 133, the second pipe segment is configured to enable communication between the mode switching mechanism 133 and the gas supply mechanism 132, and the third pipe segment is configured to enable communication between the gas supply mechanism 132 and the sealed cabinet 1. The mode switching mechanism 133 may include a three-way valve with three ports in communication with the first pipe segment, the second pipe segment, and the external environment, respectively. The power mechanism 136 and one first detection module 12 are disposed in the first pipe segment, and the first detection module 12 is located between the power mechanism 136 and the sealed cabinet 1; and the other first detection module 12 is disposed in the third pipe segment. The pressure stabilization mechanism 135 is in communication with the gas replenishment mechanism 134 through the gas supply pipe 131, and the pressure stabilization mechanism 135 is also in communication with the second pipe segment and the third pipe segment.

The gas replenishment mechanism 134 supplies the protective gas. The pressure stabilization mechanism 135 stabilizes pressure of the protective gas output from the gas replenishment mechanism 134 and then delivers the protective gas to the third pipe segment, and the third pipe segment delivers the protective gas into the sealed cabinet 1. The protective gas discharged from the sealed cabinet 1 is delivered to the mode switching mechanism 133 through the first pipe segment. Based on a gas circulation mode of the protective gas, the mode switching mechanism 133 delivers the protective gas to the external environment to achieve external circulation of the protective gas or delivers the protective gas to the pressure stabilization mechanism 135 through the second pipe segment, enabling the protective gas to circulate in the gas transmission pipe 11 and the sealed cabinet 1, thereby achieving internal circulation of the protective gas.

Optionally, the gas supply module 13 further includes: a control mechanism electrically connected to the first detection module 12, the mode switching mechanism 133, the gas replenishment mechanism 134, the pressure stabilization mechanism 135, the power mechanism 136, and the second detection module 137, respectively, so as to achieve automated control of these components or assemblies.

Specifically, the control mechanism is configured to acquire the gas parameters from the first detection module 12 and generate a first control signal and a second control signal based on the gas parameters; the gas replenishment mechanism 134 is configured to acquire the first control signal from the control mechanism and, based on the first control signal, supply the protective gas to the gas transmission pipe 11 or stop supplying the protective gas; and the pressure stabilization mechanism 135 is configured to stabilize pressure of the protective gas output from the gas replenishment mechanism 134 under control of the control mechanism and then delivers the protective gas to the gas transmission pipe 11. The mode switching mechanism 133 is configured to acquire the second control signal from the control mechanism and, based on the second control signal, control the gas transmission pipe 11 to be in communication with the gas supply mechanism 132 or the external environment to switch gas circulation modes of the protective gas.

The control mechanism controls the three-way valve through the second control signal to enable communication between the first pipe segment and the second pipe segment, enabling the protective gas to form an internal circulation in the first pipe segment, the second pipe segment, and the third pipe segment of the gas transmission pipe 11, thereby controlling the protective gas to enter the internal circulation mode. Alternatively, the control mechanism controls the three-way valve through the second control signal to disable communication between the first pipe segment and the second pipe segment and enable communication between the first pipe segment and the external environment, thereby controlling the protective gas to enter the external circulation mode.

In this embodiment, the protective gas can be supplied through the gas supply mechanism 132, and switching of gas circulation modes of the protective gas can be achieved through the mode switching mechanism 133, allowing the gas circulation modes to be switched based on the gas parameters of the protective gas in the sealed cabinet, thereby allowing the supply of the protective gas to better met a current condition of the sealed cabinet, improving the accuracy of gas supply to the sealed cabinet 1, and further mitigating the issues such as thermal runaway in the sealed cabinet.

In this embodiment, the gas replenishment mechanism 134 and the pressure stabilization mechanism 135 allow the gas supply mechanism 132 to not only supply the gas to the sealed cabinet but also regulate the pressure or flow rate of the protective gas. This can further mitigate the issues such as thermal runaway in the sealed cabinet and reduce dissipation of the protective gas.

In this embodiment, the power mechanism 136 can promote circulation of the protective gas in the gas transmission pipe 11, thereby improving the efficiency of dissipating heat or other substances from the sealed cabinet by the protective gas.

The second detection module 137 transmits a gas replenishment amount acquired to the control mechanism, and the control mechanism may acquire a gas leakage amount of the gas protection system based on the gas replenishment amount.

In this embodiment, gas parameters of the gas replenishment mechanism 134 are acquired through the second detection module 137, facilitating gas supply control by the control mechanism and improving the accuracy of gas supply to the sealed cabinet.

In other embodiments, the gas parameters acquired by the two first detection modules may be the same or different.

In some embodiments, as shown in FIG. 2, FIG. 2 is a schematic structural diagram of an embodiment of a gas transmission pipe and a first detection module according to this application. The first detection module 12 of this embodiment includes a temperature and humidity detection mechanism 121, a pressure detection mechanism 122, and a flow rate detection mechanism 123.

In this embodiment, a gas temperature, a gas humidity, a gas pressure, and a gas flow rate of the protective gas in the gas transmission pipe 11 can be acquired through the temperature and humidity detection mechanism 121, the pressure detection mechanism 122, and the flow rate detection mechanism 123.

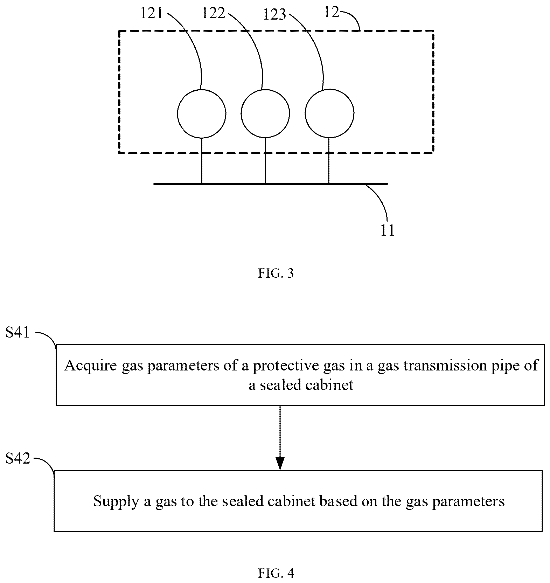

This application further proposes an energy storage system. As shown in FIG. 3, FIG. 3 is a schematic structural diagram of an embodiment of an energy storage system and a gas transmission pipe according to this application. The energy storage system of this embodiment includes a sealed cabinet 1 and a gas protection system 10, where the sealed cabinet 1 is provided with an energy storage component 2 inside; and a gas transmission pipe 11 of the gas protection system 10 is in communication with the sealed cabinet 1 to enable input and output of a protective gas to and from the sealed cabinet 1.

The specific structure and operating principle of the gas protection system 10 may refer to the above embodiments.

Optionally, the energy storage system of this embodiment includes: a plurality of sealed cabinets 1 connected in parallel, where the gas transmission pipe 11 is provided with a plurality of branch pipes 113 at an end proximate to the sealed cabinets 1, the plurality of branch pipes 113 are in communication with the plurality of sealed cabinets 1 in a one-to-one correspondence to supply the gas to the plurality of sealed cabinets 1.

In this embodiment, the plurality of sealed cabinets 1 and the energy storage components 2 in the sealed cabinets form an energy storage valve 3; and each sealed cabinet 1 may also be provided with a plurality of electrical boxes, and the electrical box is provided with the energy storage component 2. The energy storage component 2 may be an electrical energy storage component, for example, an energy storage battery or a power module.

Optionally, the energy storage valve 3 of this embodiment may be a multi-layer high-voltage direct-connected energy storage valve, and the gas protection system 10 may control a nitrogen protection system based on detection of gas parameters of the protective gas, enabling reliable operation of batteries in the sealed electrical cabinet in normal operation and thermal runaway states.

The energy storage system of this application may be an energy storage power station or a battery container.

In related art, in the normal operation state, nitrogen is filled into a battery pack by controlling a valve. This is not suitable for high-voltage direct-connected energy storage valves. Due to high-voltage electromagnetic interference, control and power supply for the valve are difficultly achieved. In contrast, in this application, the detection modules are disposed in the gas transmission pipe, reducing electromagnetic interference of the sealed electrical cabinet on the detection modules.

Furthermore, in this application, a gas replenishment parameter detection module, that is, the second detection module, is disposed between the gas replenishment mechanism and the pressure stabilization mechanism, enabling calculation of a leakage rate of the gas protection system, and achieving effective early warning and quantitative assessment of system leakage.

This application further proposes a gas protection method. As shown in FIG. 4, FIG. 4 is a schematic flowchart of an embodiment of a gas protection method according to this application. The gas protection method of this embodiment may be applied to the above gas protection system. The gas protection method of this embodiment specifically includes the following steps:
Step S41: Acquire gas parameters of a protective gas in a gas transmission pipe of a sealed cabinet.

A first detection module may be disposed in the gas transmission pipe of the sealed cabinet, and the gas parameters of the protective gas in the gas transmission pipe are acquired through the first detection module.

In some embodiments, the first detection module includes at least one of a temperature and humidity detection mechanism, a pressure detection mechanism, and a flow rate detection mechanism. The gas parameters of this embodiment may include at least one of a gas temperature, a gas humidity, a gas pressure, and a gas flow rate, which may be acquired through corresponding detection mechanisms.

Step S42: Supply a gas to the sealed cabinet based on the gas parameters.

In this embodiment, a gas supply module may be controlled based on the above gas parameters to supply the gas to the sealed cabinet.

In this embodiment, input and output of the protective gas in the sealed cabinet can be achieved through the gas transmission pipe. The first detection module disposed in the gas transmission pipe in communication with the sealed cabinet is configured to acquire gas parameters of the protective gas in the gas transmission pipe. This configuration allows the first detection module to be positioned away from the sealed cabinet, thereby reducing interference of the sealed cabinet on the first detection module and improving the accuracy of gas parameter detection. Furthermore, in this embodiment, the gas parameters of the protective gas in the gas transmission pipe are further acquired from the first detection module, and the gas is supplied to the sealed cabinet based on the gas parameters, enabling monitoring of the protective gas in the sealed cabinet and improving the accuracy of gas supply to the sealed cabinet. Thus, accurate monitoring of gas supply to the sealed cabinet can be achieved in this embodiment, ensuring controllable protective gas parameters during normal operation of the sealed cabinet, significantly mitigating the issues such as thermal runaway in the sealed cabinet, and enabling effective discharge of thermal failure gases in a thermal failure state of the sealed cabinet.

In some embodiments, the gas transmission pipe includes an intake pipe and an exhaust pipe, and the gas parameters include intake gas parameters and exhaust gas parameters; and the intake gas parameters of the protective gas in the intake pipe of the sealed cabinet and the exhaust gas parameters of the protective gas in the exhaust pipe of the sealed cabinet may be acquired through two first detection modules, respectively.

In these embodiments, monitoring of the intake and exhaust of the protective gas in the sealed cabinet can be achieved, thereby further improving the monitoring accuracy of the protective gas in the sealed cabinet, improving the accuracy of gas supply to the sealed cabinet, and further mitigating the issues such as thermal runaway in the sealed cabinet.

In some embodiments, the intake gas parameters include an intake temperature, and the exhaust gas parameters include an exhaust temperature; and the step of supplying a gas to the sealed cabinet based on the gas parameters may include: in response to the exhaust temperature or the intake temperature being greater than or equal to a temperature threshold, supplying the gas to the sealed cabinet through the intake pipe at a first preset flow rate and discharging the protective gas in the sealed cabinet to an external environment through the exhaust pipe.

When an energy storage valve is used as an example, during normal operation of the energy storage valve, a maximum allowable gas temperature in the sealed electrical cabinet is T3, that is, the temperature threshold. When an exhaust temperature T2 is greater than or equal to T3 or an intake temperature T1 is greater than or equal to T3, it can be determined that the sealed electrical cabinet may experience the thermal failure issue, and an external circulation mode is enabled to release heat from the protective gas in the sealed electrical cabinet. Specifically, a mode switching mechanism is controlled to enable conduction between a first pipe segment and an external environment so as to discharge a high-temperature protective gas out of the system, and a gas replenishment mechanism is controlled to initiate a gas replenishment mode so as to replenish a new protective gas to a pressure stabilization mechanism, so that the new protective gas is replenished by the pressure stabilization mechanism to a third pipe segment to maintain system operation.

In these embodiments, the thermal failure issue can be monitored and mitigated through the intake temperature or the exhaust temperature.

In some embodiments, the intake gas parameters include an intake temperature, and the exhaust gas parameters include an exhaust temperature; and the step of supplying a gas to the sealed cabinet based on the gas parameters includes: in response to a temperature difference between the exhaust temperature and the intake temperature being greater than or equal to a difference threshold, supplying the gas to the sealed cabinet through the intake pipe at a first preset flow rate and discharging the protective gas in the sealed cabinet to an external environment through the exhaust pipe.

When an energy storage valve is used as an example, during normal operation of the energy storage valve, a normal inlet-outlet temperature difference allowed for a single energy storage valve is T4, that is, the difference threshold. When a difference T2 - T1 between an exhaust temperature T2 and an intake temperature T1 is greater than or equal to T4, it can be determined that the sealed electrical cabinet may experience the thermal failure issue, and an external circulation mode is enabled to release heat from the protective gas in the sealed electrical cabinet. Specifically, a mode switching mechanism is controlled to enable conduction between a first pipe segment and an external environment so as to discharge a high-temperature protective gas out of the system, and a gas replenishment mechanism is controlled to initiate a gas replenishment mode so as to replenish a new protective gas to a pressure stabilization mechanism, so that the new protective gas is replenished by the pressure stabilization mechanism to a third pipe segment to maintain system operation.

In these embodiments, the thermal failure issue can be monitored and mitigated through the temperature difference between the intake temperature and the exhaust temperature.

In some embodiments, the intake gas parameters include an intake humidity, and the exhaust gas parameters include an exhaust humidity; and the step of supplying a gas to the sealed cabinet based on the gas parameters includes: in response to the exhaust humidity or the intake humidity being greater than or equal to a humidity threshold, supplying gas to the sealed cabinet through the intake pipe at a first preset flow rate and discharging the protective gas in the sealed cabinet to an external environment through the exhaust pipe.

When an energy storage valve is used as an example, during normal operation of the energy storage valve, a maximum allowable gas humidity in the sealed electrical cabinet is H3, that is, the humidity threshold. When an exhaust humidity or an intake humidity H2 is greater than or equal to H3, it can be determined that the sealed electrical cabinet may experience the thermal failure issue, and an external circulation mode is enabled to release heat from the protective gas in the sealed electrical cabinet. Specifically, a mode switching mechanism is controlled to enable conduction between a first pipe segment and an external environment so as to discharge a high-temperature protective gas out of the system, and a gas replenishment mechanism is controlled to initiate a gas replenishment mode so as to replenish a new protective gas to a pressure stabilization mechanism, so that the new protective gas is replenished by the pressure stabilization mechanism to a third pipe segment to maintain system operation.

In these embodiments, the thermal failure issue can be monitored and mitigated through the exhaust humidity or the intake humidity.

In other embodiments, the exhaust humidity and the intake humidity may be comprehensively considered to determine the thermal failure issue.

In some embodiments, the intake gas parameters include an intake pressure and/or an intake flow rate, and the exhaust gas parameters include an exhaust pressure and/or an exhaust flow rate; and the step of supplying a gas to the sealed cabinet based on the gas parameters includes: in response to the intake pressure being less than or equal to a first intake pressure threshold and greater than a second intake pressure threshold, and/or the intake flow rate being less than or equal to a first intake flow rate threshold and greater than a second intake flow rate threshold, supplying the gas to the sealed cabinet through the intake pipe at a first preset flow rate and discharging the protective gas in the sealed cabinet to an external environment through the exhaust pipe; or in response to the exhaust pressure being less than or equal to a first exhaust pressure threshold and greater than a second exhaust pressure threshold, and/or the exhaust flow rate being less than or equal to a first exhaust flow rate threshold and greater than a second exhaust flow rate threshold, supplying the gas to the sealed cabinet through the intake pipe at a first preset flow rate and discharging the protective gas in the sealed cabinet to an external environment through the exhaust pipe.

The first preset flow rate refers to a gas replenishment flow rate capable of compensating for slight gas leakage in the gas protection system, which may be set based on a gas leakage amount.

When an energy storage valve is used as an example, during normal operation of the energy storage valve, a normal operating pressure of the system is P3, that is, the first intake pressure threshold as well as the first exhaust pressure threshold, and a flow rate is F3, that is, the second intake flow rate threshold as well as the second exhaust flow rate threshold; during slight leakage in the system, a pressure is P4, that is, the second intake pressure threshold as well as the second exhaust pressure threshold, and a flow rate is F4, that is, the second intake flow rate threshold as well as the second exhaust flow rate threshold.

When an intake pressure P1 satisfies P4 < P1 ≤ P3 and/or an intake flow rate F1 satisfies F4 < F1 ≤ F3, or when an exhaust pressure P2 satisfies P4 < P2 ≤ P3 and/or an intake flow rate F2 satisfies F4 < F2 ≤ F3, it can be determined that the sealed electrical cabinet has a slight gas leakage issue, and an internal circulation mode is enabled. Specifically, a mode switching mechanism is controlled to enable conduction between a first pipe segment and a second pipe segment, and a gas replenishment mechanism is controlled to initiate a gas replenishment mode so as to replenish a new protective gas to a pressure stabilization mechanism, so that the new protective gas is replenished by the pressure stabilization mechanism to a third pipe segment to restore the system pressure to the normal operating pressure.

The gas replenishment mode refers to an operating mode in which the gas replenishment mechanism supplies the gas to the gas transmission pipe.

In these embodiments, the slight gas leakage can be monitored and the gas leakage issue can be mitigated through the gas pressure and/or the gas flow rate.

In some embodiments, the step of supplying a gas to the sealed cabinet based on the gas parameters further includes: in response to the intake pressure being less than or equal to the second intake pressure threshold and greater than a third intake pressure threshold, and/or the intake flow rate being less than or equal to the second intake flow rate threshold and greater than a third intake flow rate threshold, supplying the gas to the sealed cabinet through the intake pipe at a second preset flow rate and discharging the protective gas in the sealed cabinet to an external environment through the exhaust pipe; or in response to the exhaust pressure being less than or equal to the second exhaust pressure threshold and greater than a third exhaust pressure threshold, and/or the exhaust flow rate being less than or equal to the second exhaust flow rate threshold and greater than a third exhaust flow rate threshold, supplying the gas to the sealed cabinet through the intake pipe at a second preset flow rate and discharging the protective gas in the sealed cabinet to an external environment through the exhaust pipe; where the second preset flow rate is less than the first preset flow rate.

The first preset flow rate refers to a gas replenishment flow rate capable of compensating for slightly severe gas leakage in the gas protection system, which may be set based on a gas leakage amount.

When an energy storage valve is used as an example, during normal operation of the energy storage valve, a normal operating pressure of the system is P3, that is, the first intake pressure threshold as well as the first exhaust pressure threshold, and a flow rate is F3, that is, the first intake flow rate threshold as well as the first exhaust flow rate threshold; during slight leakage in the system, a pressure is P4, that is, the second intake pressure threshold as well as the second exhaust pressure threshold, and a flow rate is F4, that is, the second intake flow rate threshold as well as the second exhaust flow rate threshold; during severe leakage in the system, a pressure is P5, that is, the third intake pressure threshold as well as the third exhaust pressure threshold, and a flow rate is F5, that is, the third flow pressure threshold as well as the third exhaust flow rate threshold.

When an intake pressure P1 satisfies P5 < P1 ≤ P4 and/or an intake flow rate F1 satisfies F5 < F1 ≤ F4, or when an exhaust pressure P2 satisfies P5 < P2 ≤ P4 and/or an intake flow rate F2 satisfies F5 < F2 ≤ F4, it can be determined that the sealed electrical cabinet has a relatively severe gas leakage issue, and an internal circulation mode is enabled. Specifically, a mode switching mechanism is controlled to enable conduction between a first pipe segment and a second pipe segment, and a gas replenishment mechanism is controlled to initiate a gas replenishment mode, but a gas replenishment amount is reduced, that is, the second preset flow rate is less than the first preset flow rate, so as to replenish a new protective gas to a pressure stabilization mechanism, so that the new protective gas is replenished by the pressure stabilization mechanism to a third pipe segment to restore the system pressure to be slightly lower than the normal operating pressure.

In these embodiments, relatively severe gas leakage can be monitored and the gas leakage issue can be mitigated through the gas pressure and/or the gas flow rate.

In some embodiments, the step of supplying a gas to the sealed cabinet based on the gas parameters further includes: in response to the intake pressure being less than or equal to the third intake pressure threshold, and/or the intake flow rate being less than or equal to the third intake flow rate threshold, controlling the intake pipe to stop supplying the gas to the sealed cabinet and discharging the protective gas in the sealed cabinet to an external environment through the exhaust pipe; or in response to the exhaust pressure being less than or equal to the third exhaust pressure threshold, and/or the exhaust flow rate being less than or equal to the third exhaust flow rate threshold, controlling the intake pipe to stop supplying the gas to the sealed cabinet and discharging the protective gas in the sealed cabinet to an external environment through the exhaust pipe.

When an intake pressure P1 is less than or equal to P5 and/or an intake flow rate F1 is less than or equal to F5, it can be determined that the sealed cabinet has a very severe gas leakage issue, and an external circulation mode is enabled. Specifically, a mode switching mechanism is controlled to enable conduction between a first pipe segment and an external environment, and a gas replenishment mechanism is controlled to stop, maintaining a negative pressure in the system to prevent the gas from leaking into a valve hall, that is, an enclosure of the energy storage valve.

In these embodiments, very severe gas leakage can be monitored and the gas leakage issue can be mitigated through the gas pressure and/or the gas flow rate.

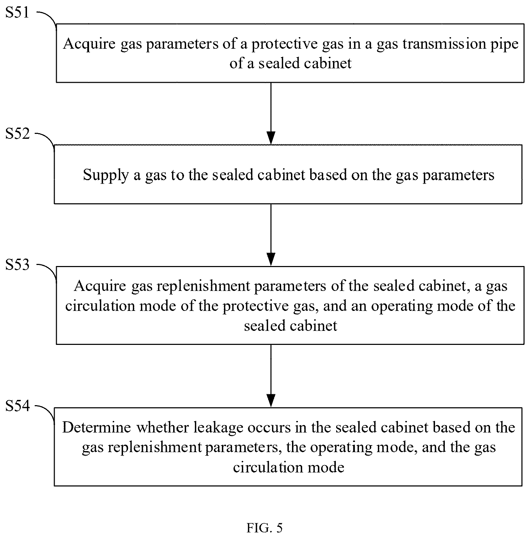

In another embodiment, as shown in FIG. 5, FIG. 5 is a schematic flowchart of another embodiment of a gas protection method according to this application. The gas protection method of this embodiment may be applied to the above gas protection apparatus. The gas protection method of this embodiment specifically includes the following steps:
Step S51: Acquire gas parameters of a protective gas in a gas transmission pipe of a sealed cabinet.

The specific embodiments may refer to the above embodiments.

Step S52: Supply a gas to the sealed cabinet based on the gas parameters.

The specific embodiments may refer to the above embodiments.

Step S53: Acquire gas replenishment parameters of the sealed cabinet, a gas circulation mode of the protective gas, and an operating mode of the sealed cabinet.

Step S54: Determine whether leakage occurs in the sealed cabinet based on the gas replenishment parameters, the operating mode, and the gas circulation mode.

In this embodiment, further acquiring the gas replenishment parameters, the gas circulation mode, and the operating mode of the sealed cabinet, and determining whether leakage occurs in the sealed cabinet based on the gas replenishment parameters, the operating mode, and the gas circulation mode can further improve the accuracy of monitoring of gas supply to the sealed cabinet and mitigate the risk of safety incidents. Monitoring of the gas pressure and monitoring of the flow rate cannot obtain the specific leakage rate of the protective gas in the gas protection system. In this embodiment, the leakage rate of the protective gas can also be calculated based on a gas replenishment amount and an exhaust flow rate.

The operating mode of the sealed cabinet refers to an operating state of the sealed cabinet, including a normal operating mode, that is, operating in a normal state, and an abnormal operating mode, that is, operating in an abnormal state, for example, operating in a thermal runaway state.

In other embodiments, Step S53 and Step S54 may be performed synchronously or asynchronously with Step S51 and Step S52.

In some embodiments, the gas replenishment parameters include a gas replenishment amount, and the gas replenishment amount may be acquired through a second detection module disposed between a gas replenishment mechanism and a pressure stabilization mechanism. The step of determining whether leakage occurs in the gas protection system based on the gas replenishment parameters, the operating mode, and the gas circulation mode includes: in response to the operating mode being a normal mode, the gas circulation mode being an internal circulation mode, and the gas replenishment amount being greater than zero, determining that leakage of the protective gas occurs.

When an energy storage valve is used as an example, in a case that the energy storage valve is in a normal operating mode, that is, operating in a normal state, and the gas circulation mode is an internal circulation mode, if a gas replenishment amount F6 of the gas replenishment mechanism acquired through the second detection module is equal to 0, it can be determined that no leakage occurs in the gas protection system; and if the gas replenishment amount F6 is greater than zero, it can be determined that leakage of the protective gas occurs, and the gas replenishment amount F6 represents a leakage amount of the protective gas, where a leakage rate can be calculated based on the leakage amount.

When the sealed cabinet is in the normal mode and the protective gas is in the internal circulation mode, the gas replenishment amount can be monitored to determine whether leakage of the protective gas occurs.

In some embodiments, the gas replenishment parameters include a gas replenishment amount; and the step of determining whether leakage occurs in the gas protection system based on the gas replenishment parameters, the operating mode, and the gas circulation mode includes: in response to the operating mode being a normal mode, the gas circulation mode being an external circulation mode, and a difference between the gas replenishment amount and an exhaust flow rate of the gas transmission pipe being greater than zero, determining that leakage of the protective gas occurs.

When an energy storage valve is used as an example, in a case that the energy storage valve is in a normal operating mode, that is, operating in a normal state, and the gas circulation mode is an external circulation mode, if a gas replenishment amount F6 is equal to an exhaust flow rate of the gas transmission pipe, that is, F6 - F2 = 0, it can be determined that no leakage of the protective gas occurs; and if F6 - F2 > 0, it can be determined that leakage of the protective gas occurs, and a leakage amount is F6 - F2, where a leakage rate can be calculated based on the leakage amount.

When the sealed cabinet is in the normal mode and the protective gas is in the external circulation mode, whether leakage of the protective gas occurs can be determined based on the gas replenishment amount and the exhaust flow rate.

In some embodiments, the gas replenishment parameters include a gas replenishment amount; and the step of determining whether leakage occurs in the gas protection system based on the gas replenishment parameters, the operating mode, and the gas circulation mode includes: in response to the operating mode being a thermal failure mode, the gas circulation mode being an external circulation mode, and a difference between the gas replenishment amount and an exhaust flow rate of the gas transmission pipe being greater than zero, determining that the gas protection system has leakage outward; or in response to the operating mode being a thermal failure mode and the difference between the gas replenishment amount and the exhaust flow rate of the gas transmission pipe being less than zero, determining that there is leakage from the external environment to the gas protection system.

When an energy storage valve is used as an example, in a case that the energy storage valve is in a thermal failure mode and the protective gas is in an external circulation mode, if a gas replenishment amount F6 is equal to an exhaust flow rate of the gas transmission pipe, that is, F6 - F2 = 0, it can be determined that no leakage occurs in the gas protection system; if the gas replenishment amount F6 is greater than the exhaust flow rate of the gas transmission pipe, that is, F6 - F2 > 0, it can be determined that there is leakage of the protective gas from the gas protection system to the environment, and a leakage rate is calculated; and if the gas replenishment amount F6 is less than the exhaust flow rate of the gas transmission pipe, that is, F6 - F2 < 0, it can be determined that air in the environment enters the gas protection system, and a leakage rate can be calculated.

When the sealed cabinet is in the thermal failure mode and the protective gas is in the external circulation mode, the gas replenishment amount F6 and the exhaust flow rate can be used for determining whether leakage of the protective gas occurs and identifying the leakage cause.

An entity executing the above gas protection method may be a control mechanism.

The gas protection system provided by this application enables input and output of the protective gas in the sealed cabinet through the gas transmission pipe. The first detection module disposed in the gas transmission pipe in communication with the sealed cabinet is configured to acquire the gas parameters of the protective gas in the gas transmission pipe. This configuration allows the first detection module to be positioned away from the sealed cabinet, thereby reducing interference of the sealed cabinet on the first detection module and improving the accuracy of gas parameter detection. Furthermore, in this application, the gas supply module is further configured to acquire the gas parameters of the protective gas in the gas transmission pipe from the first detection module and supply the gas to the sealed cabinet based on the gas parameters, enabling monitoring of the protective gas in the sealed cabinet and improving the accuracy of gas supply to the sealed cabinet. Thus, accurate monitoring of gas supply to the sealed cabinet can be achieved in this application, significantly mitigating the issues such as thermal runaway in the sealed cabinet.

Furthermore, in this application, gas parameter detection modules are respectively disposed at an end of the intake pipe proximate to the sealed cabinet and at an end of the exhaust pipe proximate to the sealed cabinet. Through comparison of the temperature, the humidity, the pressure, and the flow rate, the gas protection system executes different action commands, ensuring controllable temperature and humidity of the protective gas during normal operation of an energy storage valve and the like, and enabling effective discharge of thermal failure gases in a thermal failure state of the energy storage valve.

Furthermore, in this application, a gas replenishment parameter detection module, that is, the second detection module, is disposed between the gas replenishment mechanism and the pressure stabilization mechanism, enabling calculation of a leakage rate of the gas protection system, and achieving effective early warning and quantitative assessment of system leakage.

The foregoing descriptions are merely the embodiments of this application, but are not intended to limit the patent scope of this application. All equivalent structural or equivalent process transformations made by using the content of the specification and accompanying drawings of this application or directly/indirectly used in other related technical fields are included in the patent protection scope of this application.

## Claims

1. A gas protection system configured to provide gas protection for a sealed cabinet, wherein the gas protection system comprises:
a gas transmission pipe in communication with the sealed cabinet;
a first detection module disposed in the gas transmission pipe; and
a gas supply module configured to acquire gas parameters of a protective gas in the gas transmission pipe from the first detection module and supply a gas to the sealed cabinet based on the gas parameters.

2. The gas protection system according to claim 1, wherein the first detection module comprises at least one of a temperature and humidity detection mechanism, a pressure detection mechanism, and a flow rate detection mechanism.

3. The gas protection system according to claim 1 or 2, wherein the gas transmission pipe comprises an intake pipe and an exhaust pipe, and the gas protection system comprises two first detection modules respectively disposed in the exhaust pipe and the intake pipe.

4. The gas protection system according to any one of claims 1 to 3, wherein the gas supply module comprises:
a control mechanism connected to the first detection module, wherein the control mechanism is configured to acquire the gas parameters from the first detection module and generate a first control signal based on the gas parameters; and
a gas supply mechanism in communication with the gas transmission pipe and configured to acquire the first control signal from the control mechanism and supply the protective gas to the gas transmission pipe based on the first control signal.

5. The gas protection system according to claim 4, wherein the gas supply module further comprises:
a mode switching mechanism disposed on the gas transmission pipe;
wherein the gas transmission pipe comprises:
a first pipe segment in communication with both an exhaust port of the sealed cabinet and the mode switching mechanism;
a second pipe segment in communication with both the mode switching mechanism and the gas supply mechanism; and
a third pipe segment in communication with both an intake port of the sealed cabinet and the gas supply mechanism; wherein
the control mechanism is configured to generate a second control signal based on the gas parameters, and the mode switching mechanism is configured to acquire the second control signal from the control mechanism and, based on the second control signal, enable communication between the first pipe segment and the second pipe segment while disabling communication between the first pipe segment and an external environment, or disable communication between the first pipe segment and the second pipe segment while enabling communication between the first pipe segment and the external environment.

6. The gas protection system according to claim 4 or 5, wherein the gas supply mechanism comprises:
a gas replenishment mechanism connected to the control mechanism and configured to supply the protective gas or stop supplying the protective gas under control of the control mechanism.

7. The gas protection system according to claim 6, wherein the gas supply mechanism further comprises:
a pressure stabilization mechanism connected to the control mechanism and in communication with the gas replenishment mechanism through a gas supply pipe, wherein the pressure stabilization mechanism is also in communication with the gas transmission pipe, and the pressure stabilization mechanism is configured to stabilize pressure of the protective gas output from the gas replenishment mechanism under control of the control mechanism and then deliver the protective gas to the gas transmission pipe.

8. The gas protection system according to claim 7, wherein the gas supply mechanism further comprises:
a second detection module disposed in the gas supply pipe and connected to the control mechanism, wherein the second detection module is configured to transmit gas replenishment parameters acquired to the control mechanism.

9. A gas protection method, wherein the gas protection method comprises:
acquiring gas parameters of a protective gas in a gas transmission pipe of a sealed cabinet; and
supplying a gas to the sealed cabinet based on the gas parameters.

10. The gas protection method according to claim 9, wherein the gas transmission pipe comprises an intake pipe and an exhaust pipe, and the gas parameters comprise intake gas parameters and exhaust gas parameters; and the acquiring gas parameters of a protective gas in a gas transmission pipe of a sealed cabinet comprises:
acquiring the intake gas parameters of the protective gas in the intake pipe and the exhaust gas parameters of the protective gas in the exhaust pipe, respectively.

11. The gas protection method according to claim 10, wherein the intake gas parameters comprise an intake temperature, and the exhaust gas parameters comprise an exhaust temperature; and the supplying a gas to the sealed cabinet based on the gas parameters comprises:
in response to the exhaust temperature or the intake temperature being greater than or equal to a temperature threshold, or a temperature difference between the exhaust temperature and the intake temperature being greater than or equal to a difference threshold, supplying the gas to the sealed cabinet through the intake pipe at a first preset flow rate and discharging the protective gas in the sealed cabinet to an external environment through the exhaust pipe.

12. The gas protection method according to claim 10, wherein the intake gas parameters comprise an intake humidity, and the exhaust gas parameters comprise an exhaust humidity; and the supplying a gas to the sealed cabinet based on the gas parameters comprises:
in response to the exhaust humidity or the intake humidity being greater than or equal to a humidity threshold, supplying the gas to the sealed cabinet through the intake pipe at a first preset flow rate and discharging the protective gas in the sealed cabinet to an external environment through the exhaust pipe.

13. The gas protection method according to claim 10, wherein the intake gas parameters comprise an intake pressure and/or an intake flow rate, and the exhaust gas parameters comprise an exhaust pressure and/or an exhaust flow rate; and the supplying a gas to the sealed cabinet based on the gas parameters comprises:
in response to the intake pressure being less than or equal to a first intake pressure threshold and greater than a second intake pressure threshold, and/or the intake flow rate being less than or equal to a first intake flow rate threshold and greater than a second intake flow rate threshold, supplying the gas to the sealed cabinet through the intake pipe at a first preset flow rate and discharging the protective gas in the sealed cabinet to an external environment through the exhaust pipe; or
in response to the exhaust pressure being less than or equal to a first exhaust pressure threshold and greater than a second exhaust pressure threshold, and/or the exhaust flow rate being less than or equal to a first exhaust flow rate threshold and greater than a second exhaust flow rate threshold, supplying the gas to the sealed cabinet through the intake pipe at a first preset flow rate and discharging the protective gas in the sealed cabinet to an external environment through the exhaust pipe.

14. The gas protection method according to claim 13, wherein the supplying a gas to the sealed cabinet based on the gas parameters further comprises:
in response to the intake pressure being less than or equal to the second intake pressure threshold and greater than a third intake pressure threshold, and/or the intake flow rate being less than or equal to the second intake flow rate threshold and greater than a third intake flow rate threshold, supplying the gas to the sealed cabinet through the intake pipe at a second preset flow rate and discharging the protective gas in the sealed cabinet to an external environment through the exhaust pipe; or
in response to the exhaust pressure being less than or equal to the second exhaust pressure threshold and greater than a third exhaust pressure threshold, and/or the exhaust flow rate being less than or equal to the second exhaust flow rate threshold and greater than a third exhaust flow rate threshold, supplying the gas to the sealed cabinet through the intake pipe at a second preset flow rate and discharging the protective gas in the sealed cabinet to an external environment through the exhaust pipe;
wherein the second preset flow rate is less than the first preset flow rate.

15. The gas protection method according to claim 14, wherein the supplying a gas to the sealed cabinet based on the gas parameters further comprises:
in response to the intake pressure being less than or equal to the third intake pressure threshold, and/or the intake flow rate being less than or equal to the third intake flow rate threshold, controlling the intake pipe to stop supplying the gas to the sealed cabinet and discharging the protective gas in the sealed cabinet to an external environment through the exhaust pipe; or
in response to the exhaust pressure being less than or equal to the third exhaust pressure threshold, and/or the exhaust flow rate being less than or equal to the third exhaust flow rate threshold, controlling the intake pipe to stop supplying the gas to the sealed cabinet and discharging the protective gas in the sealed cabinet to an external environment through the exhaust pipe.

16. The gas protection method according to any one of claims 9 to 15, wherein the gas protection method further comprises:
acquiring gas replenishment parameters of the sealed cabinet, a gas circulation mode of the protective gas, and an operating mode of the sealed cabinet; and
determining whether leakage of the protective gas occurs based on the gas replenishment parameters, the operating mode, and the gas circulation mode.

17. The gas protection method according to claim 16, wherein the gas replenishment parameters comprise a gas replenishment amount; and the determining whether leakage of the protective gas occurs based on the gas replenishment parameters, the operating mode, and the gas circulation mode comprises:
in response to the operating mode being a normal mode, the gas circulation mode being an internal circulation mode, and the gas replenishment amount being greater than zero, determining that leakage of the protective gas occurs.

18. The gas protection method according to claim 16, wherein the gas replenishment parameters comprise a gas replenishment amount; and the determining whether leakage of the protective gas occurs based on the gas replenishment parameters, the operating mode, and the gas circulation mode comprises:
in response to the operating mode being a normal mode, the gas circulation mode being an external circulation mode, and a difference between the gas replenishment amount and an exhaust flow rate of the gas transmission pipe being greater than zero, determining that leakage of the protective gas occurs.

19. The gas protection method according to claim 16, wherein the gas replenishment parameters comprise a gas replenishment amount; and the determining whether leakage of the protective gas occurs based on the gas replenishment parameters, the operating mode, and the gas circulation mode comprises:
in response to the operating mode being a thermal failure mode, the gas circulation mode being an external circulation mode, and a difference between the gas replenishment amount and an exhaust flow rate of the gas transmission pipe being greater than zero, determining that the gas protection system has leakage outward; or
in response to the operating mode being a thermal failure mode, and the difference between the gas replenishment amount and the exhaust flow rate of the gas transmission pipe being less than zero, determining that there is leakage from the environment to the gas protection system.

20. An energy storage system, wherein the energy storage system comprises:
a sealed cabinet provided with an energy storage component inside; and
the gas protection system according to any one of claims 1 to 8, wherein the gas transmission pipe is in communication with the sealed cabinet.
